(19) Europäisches Patentamt

European Patent Office

Office européen des brevets

(11) **EP 0 741 196 B1**

(12) **EUROPÄISCHE PATENTSCHRIFT**

(45) Veröffentlichungstag und Bekanntmachung des Hinweises auf die Patenterteilung:
**04.08.1999 Patentblatt 1999/31**

(51) Int Cl.$^6$: **C23C 16/40**, C23C 16/44

(21) Anmeldenummer: **96106983.8**

(22) Anmeldetag: **03.05.1996**

(54) **Verfahren zur Abscheidung einer Siliziumoxidschicht**

Method for depositing a silicium oxide layer

Procédé pour le dépôt d'une couche de silicium

(84) Benannte Vertragsstaaten:
**AT DE FR GB IE IT**

(30) Priorität: **05.05.1995 DE 19516669**

(43) Veröffentlichungstag der Anmeldung:
**06.11.1996 Patentblatt 1996/45**

(73) Patentinhaber: **SIEMENS AKTIENGESELLSCHAFT
80333 München (DE)**

(72) Erfinder:
• **Gabric, Zvonimir
85604 Zorneding (DE)**
• **Spindler, Oswald, Dr. rer. nat.
85591 Vaterstetten (DE)**

(56) Entgegenhaltungen:
**EP-A- 0 212 691      EP-A- 0 239 664
EP-A- 0 272 140**

EP 0 741 196 B1

## Beschreibung

Die Erfindung betrifft ein Verfahren zur Abscheidung einer Siliziumoxidschicht.

Siliziumoxidschichten können unter anderem nach dem sogenannten TEOS (Tetraethylortosilikat)-Verfahren mittels einer Gasphasenabscheidung (CVD) hergestellt werden. Bekannt ist, daß die Gasphasenabscheidung durch Zugabe von Ozon im Gasfluß aktiviert wird. Nachteilig an dem ozonaktivierten TEOS-Prozeß sind die unterschiedlichen Abscheidecharakteristiken in Abhängigkeit von dem Basismaterial. So ist die Abscheiderate auf einem thermischen Oxid niedriger als auf Silizium.

Die Veröffentlichung K. Fujino, Y. Nishimoto, N. Tokumasu und K. Maeda: Dependence of Deposition Characteristics on Base Materials in TEOS and Ozone CVD at Atmospheric Pressure, J. Electrochem. Soc., Vol. 138, No. 2, February 1991, p. 550 schlägt als Verbesserung vor, zunächst eine erste Schicht bei einer niedrigen Ozonkonzentration abzuscheiden und danach eine zweite Schicht in der gewünschten Schichtdicke bei hoher Ozonkonzentration abzuscheiden. Dies hat den Nachteil, daß zwei getrennte Schichten entstehen, so daß nicht sicher verhindert werden kann, daß eine ungleichförmige Abscheidung unter Lunkerbildung und/oder Stöchiometrieschwankungen erfolgt. Darüberhinaus ist die prozeßtechnische Handhabung umständlich, da die Abscheideverhältnisse für beide Schichten neu ein gestellt werden müssen.

Auf der nachfolgend an die vorgenannte Veröffentlichung von den gleichen Autoren veröffentlichten Druckschrift: Surface Modification of Base Materials for TEOS/$O_3$ Atmospheric Pressure Chemical Vapor Deposition, J. Electrochem. Soc., Vol. 139, No. 6, June 1992, p. 1690 ist bekannt, bei einer ozonaktivierten Siliziumoxid-Gasphasenabscheidung mittels TEOS ein Stickstoff- oder Argonplasma zu verwenden. Durch die Aussetzung der Oberflächen gegenüber dem Stickstoffplasma werden die Oberflächenenergien nivelliert, um so für den anschließenden eigentlichen TEOS-Prozeß eine gleichmäßige Bekeimung der abzuscheidenden Schicht zu erzielen. Bei der Verwendung von Argonplasma werden die Oberflächenenergien dadurch egalisiert, daß die unterschiedliche Oberflächenkonstitution durch Absputtern der inhomogenen Schicht beseitigt wird. Auch diese Prozesse führen zu einer mangelhaften Schichtqualität und zu einer ungenügenden Reproduzierbarkeit, so daß sie für einen Fertigungseinsatz nicht in Frage kommen.

Der Erfindung liegt die Aufgabe zugrunde, die vorgenannten Nachteile bei einem ozonaktivierten TEOS-Prozeß zu vermeiden.

Diese Aufgabe löst die Erfindung mit den Merkmalen des Anspruchs 1. Weiterbildungen der Erfindung sind in Unteransprüchen gekennzeichnet.

Die Erfindung erzielt eine sehr homogene Siliziumoxidschicht ohne Stöchiometrieschwankungen dadurch, daß zu Beginn der Gasphasenabscheidung der TEOS-Gasfluß ein mehrfaches des Ozon-Gasflusses und beim stationären Verhältnis der Ozon-Gasfluß ein Mehrfaches des TEOS-Gasflusses ist.

Typischerweise beträgt bei einem Ausführungsbeispiel das anfängliche Gasflußverhältnis von TEOS zum ozonhaltigen Gas etwa 10, während beim nach etwa 1 1/2 Minuten erreichten stationären Gasflußverhältnis der Wert 0,4 erreicht wird.

Es ist vorteilhaft, ausgehend vom anfänglichen Gasflußverhältnis, zunächst den TEOS-Gasfluß konstant zu halten und den Ozon-Gasfluß zu steigern. Während anschließend der Ozon-Gasfluß weiter bis zu seinem stationären Endwert gesteigert wird, kann der TEOS-Gasfluß bis zu seinem stationären Endwert verringert werden. Die Veränderung erfolgt deshalb vorzugsweise nichtlinear, aber auch eine lineare Veränderung des Verhältnisses ist möglich.

Durch die Steigerung des mit einem Ozongenerator erzeugten Ozon-Gasflussess nimmt gleichzeitig während dieser Startphase der Anteil von Sauerstoff am Gesamtgasfluß ab. Dies ist in der nachfolgenden Tabelle mit Prozeßparametern eines Ausführungsbeispiels in der ersten Spalte festgelegt, während die zweite und die dritte Spalte den Gasfluß des Ozons bzw. von TEOS angeben. Bei weitgehend konstantem $O_2/O_3$-Gasfluß verändert sich deshalb das Verhältnis dieser beiden Gase von einem niedrigen Ozonanteil zu einem hohen Ozonanteil.

Die Änderung des Verhältnisses von den anfänglichen Gasflußbedingungen zu den stationären Gasflußverhältnissen erfolgt vorzugsweise kontinuierlich, in der Praxis jedoch üblicherweise in zeitlichen Abstufungen. Um die für die Desensibilisierung des Abscheideprozesses erforderlichen Bedingungen zu verbessern, wird das anfängliche Gasflußverhältnis von TEOS zu Ozon zunächst langsam, danach aber vergleichsweise schnell zum stationären Endwert geändert. Während der gesamte Startprozeß bis zum Erreichen des stationären Endwerts etwa 1 1/2 Minuten dauert, ist etwa zur Hälfte dieser Gesamtzeit der anfängliche TEOS-Gesamtfluß noch konstant geblieben, während der ozonhaltige Gasfluß etwa das 2 1/2-fache des anfänglichen Wertes beträgt. Insgesamt beträgt deshalb das Verhältnis der Gasflüsse von TEOS zu Ozon zu diesem Zeitpunkt noch etwa 4. Durch die dann einsetzenden gegensinnigen Änderungen des TEOS-Gasflusses und des Ozon-Gasflusses wird der TEOS-Gasfluß am Ende des Startprozesses auf etwa 2/3 seines anfänglichen Wertes reduziert, während der Ozonfluß mehr als das 15-fache des anfänglichen Gasflusses beträgt.

Die folgende Tabelle gibt eine Übersicht über beispielhaft mögliche Prozeßparameter. Die nicht angeführten Parameter wie Druck und Temperatur entsprechen denen eines bekannten Standardprozesses, z. B. etwa 79,98 kPa (600 Torr) und etwa 400 °C.

| Zeit | O$_2$ [sccm]* | O$_3$ [sccm] | TEOS [sccm] |
|------|------|------|------|
| 15" | 5000 | 300 | 3000 |
| 11" | 5000 | 500 | 3000 |
| 18" | 5000 | 750 | 3000 |
| 15" | 5000 | 1000 | 2800 |
| 12" | 4000 | 2000 | 2600 |
| 9" | 3000 | 3000 | 2400 |
| 6" | 2000 | 4000 | 2200 |
| 3" | 1000 | 5000 | 2000 |
| X" | --- | 5000 | 2000 |

\* sccm = Standard cm$^3$ Gasfluß

## Patentansprüche

1. Verfahren zur Abscheidung einer Siliziumoxidschicht mittels einer ozonaktivierten Gasphasenabscheidung unter Verwendung von Tetraethylortosilikat (TEOS), bei dem anfänglich der TEOS-Gasfluß ein mehrfaches des Ozon-Gasflusses und beim stationären Verhältnis der Ozon-Gasfluß ein Mehrfaches des TEOS-Gasflusses ist.

2. Verfahren nach Anspruch 1,
   **dadurch gekennzeichnet**, daß ausgehend von den anfänglichen Bedingungen der TEOS-Gasfluß vermindert und der Ozon-Gasfluß vergrößert wird.

3. Verfahren nach Anspruch 1,
   **dadurch gekennzeichnet**, daß ausgehend von den anfänglichen Verhältnissen zunächst der ozonhaltige Gasfluß gesteigert wird und der TEOS-Gasfluß konstant bleibt.

4. Verfahren nach einem der Ansprüche 1 bis 3,
   **dadurch gekennzeichnet**, daß das stationäre Verhältnis der Gasflüsse nach etwa 1 1/2 Minuten erreicht ist.

5. Verfahren nach einem der Ansprüche 1 bis 4,
   **dadurch gekennzeichnet**, daß die Veränderung des Gasflußverhälnisses von TEOS zu Ozon kontinuierlich erfolgt.

6. Verfahren nach einem der Ansprüche 1 bis 4,
   **dadurch gekennzeichnet**, daß die Veränderung des Gasflußverhältnisses von TEOS zu Ozon stufenweise erfolgt.

7. Verfahren nach einem der Ansprüche 1 bis 6,
   **dadurch gekennzeichnet**, daß die Veränderung der Gasflußverhältnisse anfänglich langsam und dann nichtlinear zunehmend erfolgt.

## Claims

1. Method for depositing a silicon oxide layer by means of an ozone-activated vapour phase deposition employing tetraethyl orthosilicate (TEOS), for which initially the TEOS gas flow is several times the ozone gas flow and, at the steady-state ratio, the ozone gas flow is several times the TEOS gas flow.

2. Method according to Claim 1, characterized in that, starting from the initial conditions, the TEOS gas flow is reduced and the ozone gas flow is increased.

3. Method according to Claim 1, characterized in that, starting from the initial ratios, the ozone-containing gas flow is raised at first, and the TEOS gas flow remains constant.

4. Method according to any one of Claims 1 to 3, characterized in that the steady-state ratio of the gas flows is reached after about $1\frac{1}{2}$ minutes.

5. Method according to any one of Claims 1 to 4, characterized in that the change in the gas flow ratio of TEOS to ozone takes place continuously.

6. Method according to any one of Claims 1 to 4, characterized in that the change in the gas flow ratio of TEOS to ozone takes place stepwise.

7. Method according to any one of Claims 1 to 6, characterized in that the change in the gas flow ratios initially takes place slowly and then at a non-linearly increasing rate.

## Revendications

1. Procédé pour déposer une couche d'oxyde de silicium par déposition en phase gazeuse activée par l'ozone, par utilisation d'orthosilicate de tétraéthyle (TEOS), dans lequel le débit gazeux du TEOS est au début plusieurs fois supérieur au débit gazeux de l'ozone, le débit gazeux de l'ozone étant plusieurs fois supérieur au débit gazeux du TEOS dans les conditions du régime permanent.

2. Procédé selon la revendication 1, caractérisé en ce que, en partant des conditions initiales, le débit gazeux du TEOS diminue et le débit gazeux de l'ozone augmente.

3. Procédé selon la revendication 1, caractérisé en ce que, en partant des conditions initiales, le débit du

**EP 0 741 196 B1**

gaz contenant de l'ozone augmente d'abord, et le débit gazeux du TEOS reste constant.

4. Procédé selon l'une des revendications 1 à 3, caractérisé en ce que le rapport en régime permanent entre les débits de gaz est atteint au bout d'environ 1,5 minutes.

5. Procédé selon l'une des revendications 1 à 4, caractérisé en ce que la variation du rapport entre le débit gazeux du TEOS et celui de l'ozone est continue.

6. Procédé selon l'une des revendications 1 à 4, caractérisé en ce que la variation du rapport entre le débit gazeux du TEOS et celui de l'ozone s'effectue par paliers.

7. Procédé selon l'une des revendications 1 à 6, caractérisé en ce que la variation du rapport entre les débits gazeux est lente au départ, puis augmente d'une manière non-linéaire.